# EUROPEAN PATENT SPECIFICATION

(11) **EP 0 457 348 B1**
(45) Date of publication and mention of the grant of the patent: **12.11.1997**
(21) Application number: 91108039.8
(22) Date of filing: 17.05.1991
(51) Int. Cl.: H03B 5/12, H03L 1/02

(54) **Oscillation circuit**
Oszillatorschaltung
Circuit oscillateur

(30) Priority: 17.05.1990 JP 128055/90
(43) Date of publication of application: 21.11.1991
(73) Proprietor: NEC CORPORATION, Tokyo (JP)
(72) Inventor: Nishijima, Kazunori, Minato-ku, Tokyo (JP)
(74) Representative: Glawe, Delfs, Moll & Partner

(56) References cited:
- US-A- 3 904 989
- US-A- 4 270 102
- PATENT ABSTRACTS OF JAPAN vol. 14, no. 183 (P-1035)12 April 1990 & JP-A-2 029 811
- THE ELECTRONIC ENGINEER. vol. 29, no. 9, September 1970, RADNOR US page 85; WALTER G. JUNG: 'SINE WAVE OSCILLATOR HAS LOGIC LEVEL OUTPUT'
- PATENT ABSTRACTS OF JAPAN vol. 9, no. 197 (E-335)(1920) 14 August 1985 & JP-A- 60 062 704

## Description

### BACKGROUND OF THE INVENTION

The present invention relates to a transistor circuit and, more particularly, to an oscillation circuit which is capable of performing a stable oscillation against a wide range of temperature change.

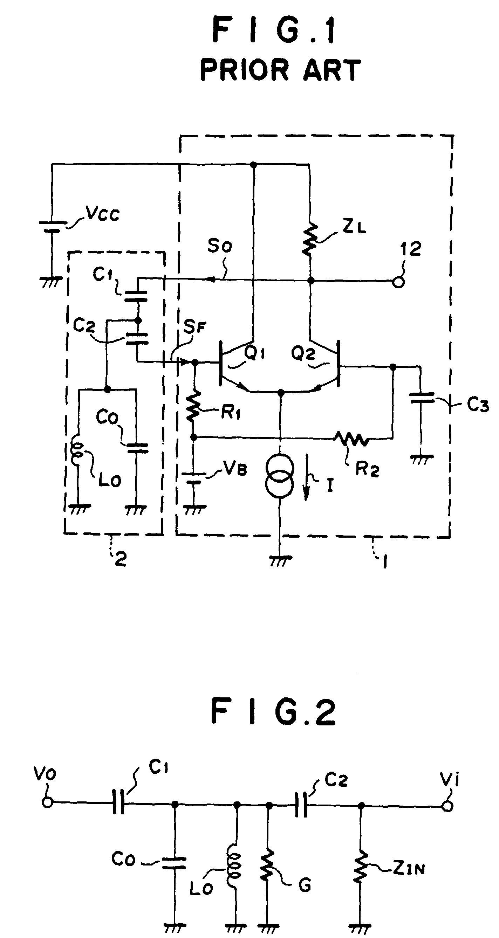

As shown in Fig. 1, a conventional oscillation circuit is constituted by a differential amplifier 1 which is supplied with a positive feedback signal S_{F} and which outputs an oscillation signal Sₒ, and a feedback circuit 2 which is supplied with the oscillation signal Sₒ. The differential amplifier 1 is constituted by a pair of transistors Q1 and Q2, a load Z_{L}, a constant current source I, bias resistors R1 and R2, a bypass capacitor C3, and a bias voltage source V_{B}. The feedback circuit 2 is constituted by coupling capacitors C1 and C2, and a resonance circuit composed of a capacitor Cₒ and an inductor Lₒ.

In the following, the operation of the conventional oscillation circuit having the above circuit construction is described. When an oscillating current is produced in the oscillation circuit, the current is resonated through the resonance circuit composed of the capacitor Cₒ and the inductor Lₒ with a resonance frequency f expressed as follows.$\text{f =} \frac{\text{1}}{\text{2π} \sqrt{{\text{L}}_{\text{0}} {\text{C}}_{\text{0}}}}$ The resonant current is then fed to the base of the transistor Q1 through the coupling capacitor C2, and amplified by the differential amplifier 1, so that an oscillation signal Sₒ is outputted from the collector of the transistor Q2 and then positively fed back to the base of the transistor Q1 through the coupling capacitors C1 and C2. As a result, oscillation with the same frequency as the resonance frequency is produced. That is, the oscillation frequency of the conventional oscillation circuit shown in Fig. 1 is expressed by the above equation (1). In the case of a high-frequency oscillation circuit, however, the oscillation frequency thereof cannot be expressed by the equation (1) because it is affected by the input impedance of the differential amplifier 1. The oscillation frequency of a high-frequency oscillation circuit is explained by making reference to the expressions given hereunder.

Fig. 2 shows the feedback circuit 2 extracted from the conventional oscillation circuit of Fig. 1 on the assumption that an input impedance of the differential amplifier 1 viewed from the base of the transistor Q1 is expressed by Z_{IN}. In Fig. 2, the ratio v₁/vₒ, that is, a feedback factor β, is expressed as follows. 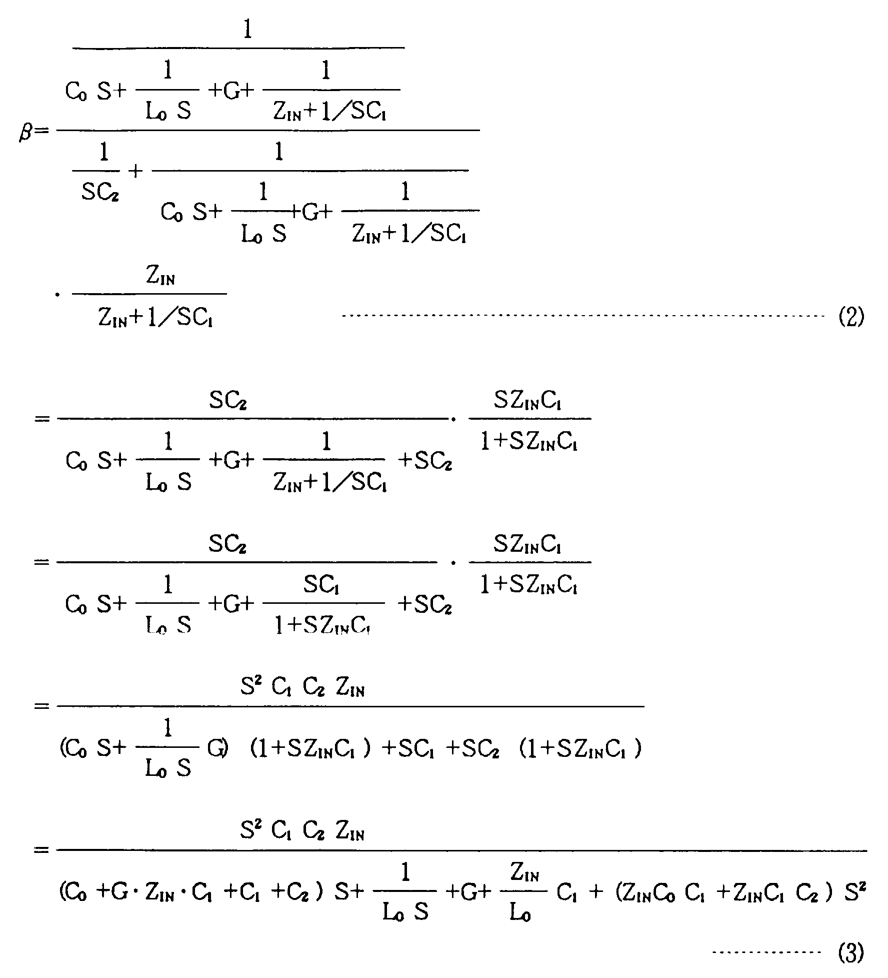 In the above expressions, S=jω, and G represents the reciprocal of the resistive component r of the coil Lₒ.

When the open gain of the differential amplifier 1 is assumed to be represented by Aₒ, a condition for oscillating ing is expressed by the following equation (4).${\text{A}}_{\text{0}} \text{β=1}$

Applying the equation (4) into the equation (3), the following equation is obtained.$\text{β=} \frac{{\text{S}}^{\text{2}} {\text{C}}_{\text{1}} {\text{C}}_{\text{2}} {\text{Z}}_{\text{IN}}}{{\text{(C}}_{\text{0}} {\text{+G·Z}}_{\text{IN}} {\text{·C}}_{\text{1}} {\text{+C}}_{\text{1}} {\text{+C}}_{\text{2}} \text{) S+} \frac{\text{1}}{{\text{L}}_{\text{0}} \text{S}} \text{+G+} \frac{{\text{Z}}_{\text{IN}}}{{\text{L}}_{\text{0}}} {\text{C}}_{\text{1}} {\text{+ (Z}}_{\text{IN}} {\text{C}}_{\text{0}} {\text{C}}_{\text{1}} {\text{+Z}}_{\text{IN}} {\text{C}}_{\text{1}} {\text{C}}_{\text{2}} {\text{) S}}^{\text{2}}} \text{=} \frac{\text{1}}{{\text{A}}_{\text{0}}}$

If the imaginary part of β is zero, the equation (5) is established and the oscillating condition is satisfied.

Here,${\text{(C}}_{\text{0}} {\text{+G· Z}}_{\text{IN}} {\text{·C}}_{\text{1}} {\text{+C}}_{\text{1}} {\text{+C}}_{\text{2}} \text{) S+} \frac{\text{1}}{{\text{L}}_{\text{0}} \text{S}} \text{=0}$

Rearranging the equation (6) by substituting S=jω thereinto, the following equation (7) is obtained.$\text{ω=} \frac{\text{1}}{\sqrt{{\text{L}}_{\text{0}} {\text{(C}}_{\text{0}} {\text{+C}}_{\text{1}} {\text{+C}}_{\text{2}} {\text{+G·Z}}_{\text{IN}} {\text{·C}}_{\text{1}} \text{)}}}$${\text{f}}_{\text{0}} \text{=} \frac{\text{1}}{\text{2π} \sqrt{{\text{L}}_{\text{0}} {\text{(C}}_{\text{0}} {\text{+C}}_{\text{1}} {\text{+C}}_{\text{2}} {\text{+G·Z}}_{\text{IN}} {\text{·C}}_{\text{1}} \text{)}}}$

The oscillation frequency fₒ of the circuit can be calculated according to the equation (7). In the equation (7), the input impedance Z_{IN} of the differential amplifier 1 may be expressed by the following equation (8) on the assumption that it is pure resistance.${\text{Z}}_{\text{IN}} {\text{≒ h}}_{\text{fe}} {\text{/g}}_{\text{m}}$ in which gₘ represents the mutual conductance of the differential amplifier 1, and h_{fe} represents the current amplification factor of the transistor concerned.

Substituting the above equation (8) into the equation (7), the following equation (9) is obtained.${\text{f}}_{\text{0}} \text{=} \frac{\text{1}}{\text{2π} \sqrt{{\text{L}}_{\text{0}} {\text{(C}}_{\text{0}} {\text{+C}}_{\text{1}} {\text{+C}}_{\text{2}} {\text{+G·h}}_{\text{fe}} {\text{·C}}_{\text{1}} {\text{/g}}_{\text{m}} \text{)}}}$

Thus, as expressed by the above equation (9), the oscillation frequency fₒ of the conventional oscillation circuit contains the mutual conductance gₘ of the differential amplifier 1 expressed by the following equation (10).${\text{g}}_{\text{m}} \text{=} \frac{\text{qI}}{\text{4kT}}$ in which k represents a Boltzmann constant, T represents an absolute temperature, and q represents an electron charge quantity.

From the above equation (10), it is understood that the mutual conductance gₘ changes as the temperature changes and, therefore, the oscillation frequency fₒ including gₘ changes as the temperature changes. That is, the temperature-depending fluctuation of the oscillation frequency of the oscillation circuit is large. Here, the temperature-depending fluctuation of the oscillation frequency fₒ is examined by substituting certain constants into the equation (9). Assuming now that G=0.001, h_{fe}=100, gₘ=0.2 (at the temperature t=-25°C ) and Cₒ=C₁=C₂ are established and I does not change as the temperature changes, the oscillation frequency f₁ at the temperature t=-25°C can be expressed by the equation (11).${\text{f}}_{\text{1}} \text{=} \frac{\text{1}}{\text{2π} \sqrt{{\text{3.5C}}_{\text{0}} {\text{L}}_{\text{0}}}}$

The mutual conductance gₘ' at the temperature t'=75°C can be expressed by the following equation (12).${\text{g}}_{\text{m}} \text{' =} \frac{\text{qI}}{\text{4kT'}} \text{=} \frac{\text{qI}}{\text{4kT}} \text{.} \frac{\text{T}}{\text{T'}} {\text{= g}}_{\text{m}} \text{.} \frac{\text{273 +t}}{\text{273 +t'}} {\text{= g}}_{\text{m}} \text{.} \frac{\text{273 -25}}{\text{273 +75}}$

Here, the value of gₘ' at the temperature t'=75°C can be calculated by substituting 0.2 for gₘ as follows:${\text{g}}_{\text{m}} \text{' ≒ 0.14}$

Accordingly, the oscillation frequency f₂ at the temperature t'=75°C can be expressed as follows.${\text{f}}_{\text{2}} \text{=} \frac{\text{1}}{\text{2π} \sqrt{{\text{3.71C}}_{\text{0}} {\text{L}}_{\text{0}}}}$$\frac{{\text{f}}_{\text{2}}}{{\text{f}}_{\text{1}}} \text{=} \frac{\frac{\text{1}}{\text{2π} \sqrt{{\text{3.71C}}_{\text{0}} {\text{L}}_{\text{0}}}}}{\frac{\text{1}}{\text{2π} \sqrt{{\text{3.5C}}_{\text{0}} {\text{L}}_{\text{0}}}}} \text{=} \sqrt{\frac{\text{3.50}}{\text{3.71}}} \text{≒ 0.97}$

Assuming now that f₁ is 480 MHz, f₂ = 0.97 × 480 = 466 MHz. Accordingly, in a temperature range of from -25°C to 75°C, the width of fluctuation of the oscillation frequency is 14 MHz. Thus, there has been a problem in that the temperature-depending fluctuation of the oscillation frequency is large.

US-A-4 270 102 discloses an oscillator circuit according to the precharacterizing part of claim 1. This circuit comprises an oscillator and a differential amplifier with a constant current source. The constant current source has a resistor and a transistor whose emitter is grounded through that resistor.

"The Electronic Engineer", Vol. 29, No. 9, September 1970, Radnor, US, W.G. Jung "Sine wave oscillator has logic level output" disclosed another oscillator circuit comprising a feedback circuit through which an output of a differential amplifier is positively feedback to an input of the differential amplifier.

Further, JP-A-60-062704 discloses a temperatur compensating circuit for a voltage controlled oscillator comprising a band-gap regulator which includes a pair of first and second transistors, whose emitter areas are different from each other, which produces a band-gap voltage proportional to a thermal voltage of said pair of transistors.

### SUMMARY OF THE INVENTION

It is, therefore, an object of the invention to overcome the drawbacks existing in the conventional oscillation circuits and to provide an improved oscillation circuit.

It is another object of the invention to provide an oscillation circuit for performing oscillation with a stable oscillation frequency against temperature changes.

In order to attain the above objects, there is provided an oscillator circuit according to claim 1. The dependent claims are related to further advantageous aspects of the present invention.

### BRIEF DESCRIPTION OF THE DRAWINGS

The above and other objects, features and advantages of the present invention will be apparent from the following description of preferred embodiments of the invention explained with reference to the accompanying drawings, in which:-
Fig. 1 is a circuit diagram showing a conventional oscillation circuit;
Fig. 2 is an equivalent circuit diagram of a feedback circuit used in the conventional oscillation circuit;
Fig. 3 is a circuit diagram showing an embodiment of the oscillation circuit according to the present invention;
Fig. 4 is a circuit diagram showing another embodiment of the oscillation circuit according to the present invention; and
Fig. 5 is a graph showing the relation of the oscillation frequency versus temperature in the oscillation circuit experimentally obtained according to the invention.

### PREFERRED EMBODIMENTS OF THE INVENTION

Throughout the following explanation, similar reference symbols or numerals refer to the same or similar elements in all the figures of the drawings.

Now, embodiments of the present invention will be described below with reference to the drawings.

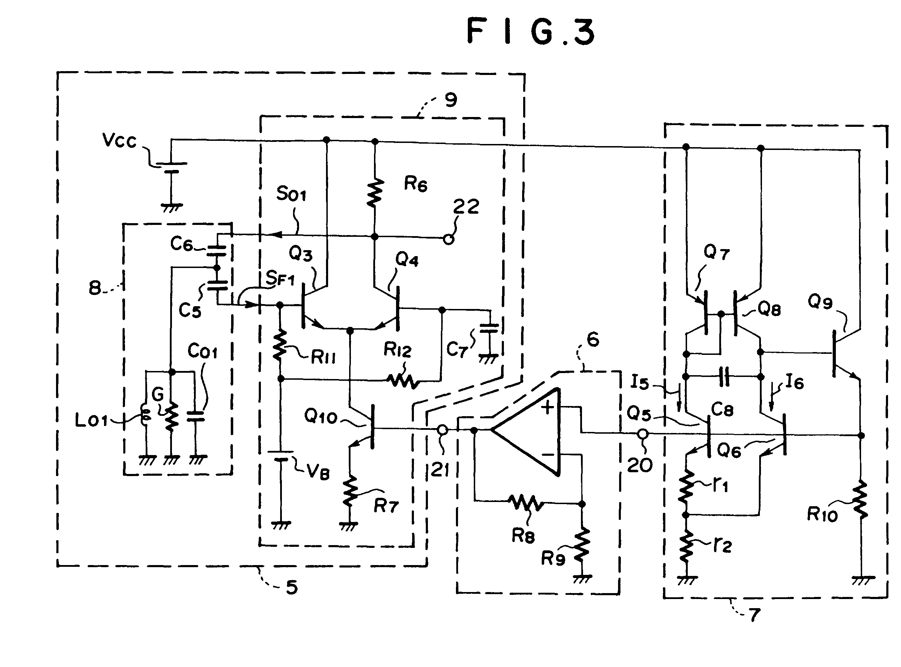

Fig. 3 shows an embodiment of the oscillation circuit according to the present invention. The oscillation circuit is constituted by an oscillator 5, an operational amplifier 6, and a band-gap regulator 7.

The oscillator 5 is constituted by a differential amplifier 9, and a feedback circuit 8. The differential amplifier 9 includes a pair of transistors Q3 and Q4. A positive feedback signal S_{F1} is supplied from the feedback circuit 8 to the base of the transistor Q3. The positive feedback signal is amplified by the differential amplifier, so that an oscillation signal Sₒ₁ is outputted from the collector of the transistor Q4 and positively fed back to the base of the transistor Q3 through coupling capacitors C₆ and C₅. R₁₁ and R₁₂ represent base bias-resistors for the transistors Q3 and Q4, respectively, V_{B} represents a base bias-source, C₇ represents a bypass capacitor, and R₆ represents a load resistor. In Fig. 3, a capacitor Cₒ₁ and an inductor Lₒ₁ in the feedback circuit 8 constitute a resonance circuit. Rₒ₁ represents a resistive component of the inductor Lₒ₁. These elements together with the coupling capacitors C₆ and C₅ determine the oscillation frequency of the circuit. The band-gap regulator 7 is constituted by transistors Q5 through Q9, resistors r₁, r₂ and R₁ₒ, and a phase-compensation capacitor C₈. The emitter area ratio of the transistors Q5 and Q6 is set to N : 1 (N>2). An output of the band-gap regulator 7, that is, a band-gap voltage, is outputted through a terminal 20. The band-gap voltage is DC-amplified by the operational amplifier 6, and then applied to the base of the transistor Q10. This transistor Q10 and a resistor R7 constitute a constant current source, and a constant current I flowing in the differential amplifier 9 is determined or controlled by the base voltage of the transistor Q10. The oscillation frequency fₒ₅ of the oscillator 5 can be calculated according to the aforementioned equation (9). That is, the oscillation frequency fₒ₅ is expressed by the following equation (14):${\text{f}}_{\text{05}} \text{=} \frac{\text{1}}{\text{2π} \sqrt{{\text{L}}_{\text{01}} {\text{(C}}_{\text{01}} {\text{+C}}_{\text{5}} {\text{+C}}_{\text{6}} {\text{+G}}_{\text{01}} {\text{· h}}_{\text{fe5}} {\text{· C}}_{\text{5}} {\text{/ g}}_{\text{m5}} \text{)}}}$ in which h_{fe5} represents the current amplification factor of the transistor concerned, and gₘ₅ represents the mutual conductance of the differential amplifier 9.

If the mutual conductance gₘ₅ in the equation (14) is constant regardless of the temperature change, the oscillation frequency fₒ₅ expressed by the equation (14) is also constant against the temperature change. The band-gap voltage V_{BG} of the band-gap regulator 7 is calculated as follows. Let I₅ and I₆ be the collector currents of the transistors Q5 and Q6, respectively. Current mirror circuit constituted by the transistors Q7 and Q8 and the feedback circuit constituted by the transistor Q9 and the resistor R10 make the collector currents I₅ and I₆ substantially equal to each other as shown in the following equation (15).${\text{I}}_{\text{5}} {\text{= I}}_{\text{6}} \text{= I}$

The base-emitter voltages of the transistors Q5 and Q6 are determined by the emitter area ratio (N) as represented by the following equations.${\text{V}}_{\text{BE (Q6)}} {\text{=V}}_{\text{BE (Q5)}} {\text{+ r}}_{\text{1}} \text{I}$${\text{v}}_{\text{T}} \text{ℓn} \frac{{\text{I}}_{\text{6}}}{{\text{I}}_{\text{S}}} {\text{=v}}_{\text{T}} \text{ℓn} \frac{{\text{I}}_{\text{5}}}{{\text{NI}}_{\text{S}}} {\text{+ r}}_{\text{1}} \text{I}$ in which V_{T} represents the thermal voltage of the respective transistors Q5 and Q6.

Rearranging the equation (17) by substituting the equation (15) into the equation (17), the following equation (18) is obtained.${\text{v}}_{\text{T}} {\text{ℓnN=r}}_{\text{1}} \text{I}$

Because the current flowing in the resistor r₂ is 2I, the emitter voltage V_{E(Q6)} of the transistor Q6 is expressed by the following equation (19) based on the equation (18).${\text{V}}_{\text{E(Q6)}} {\text{= 2Ir}}_{\text{2}} {\text{=2v}}_{\text{T}} \text{ℓnN} \frac{{\text{r}}_{\text{2}}}{{\text{r}}_{\text{1}}}$

Accordingly, the band-gap voltage V_{BG} is expressed by the following equation (20).${\text{V}}_{\text{BG}} {\text{= V}}_{\text{BE (Q6)}} {\text{+2v}}_{\text{T}} \text{ℓnN} \frac{{\text{r}}_{\text{2}}}{{\text{r}}_{\text{1}}}$

The band-gap voltage V_{BG} is amplified by the operational amplifier 6. As a result, an output voltage V_{E} expressed by the following equation (21) is obtained from the operational amplifier 6 through a terminal 21.${\text{V}}_{\text{E}} \text{= (1 +} \frac{{\text{R}}_{\text{8}}}{{\text{R}}_{\text{9}}} {\text{) V}}_{\text{BG}} \text{= (1 +} \frac{{\text{R}}_{\text{8}}}{{\text{R}}_{\text{9}}} {\text{) (V}}_{\text{BE (Q6)}} {\text{+ 2v}}_{\text{T}} \text{ℓnN} \frac{{\text{r}}_{\text{2}}}{{\text{r}}_{\text{1}}} \text{)}$

Because the output voltage V_{E} is used as the base voltage of the transistor Q10, the collector current I_{C(Q10)} of the transistor Q10 is expressed by the following equation (22).${\text{I}}_{\text{C(Q10)}} \text{=} \frac{{\text{V}}_{\text{E}} \text{- V} {\text{}}_{\text{BE} \left(\text{Q10}\right)}}{{\text{R}}_{\text{7}}} \text{=} \frac{\text{(1 +} \frac{{\text{R}}_{\text{8}}}{{\text{R}}_{\text{9}}} \text{) (V} {\text{}}_{\text{BE} \left(\text{Q6}\right)} {\text{+ 2v}}_{\text{T}} \text{ℓnN} \frac{{\text{r}}_{\text{2}}}{{\text{r}}_{\text{1}}} \text{) - V} {\text{}}_{\text{BE} \left(\text{Q10}\right)}}{{\text{R}}_{\text{7}}}$

Assuming now that the values of an input resistor R₈ and a feedback resistor R₉ of the operational amplifier 6 are selected to satisfy the following equation (23), the above equation (22) is rearranged to the following equation (24).$\text{(1 +} \frac{{\text{R}}_{\text{8}}}{{\text{R}}_{\text{9}}} {\text{) V}}_{\text{BE (Q6)}} {\text{= V}}_{\text{BE (Q10)}}$${\text{I}}_{\text{C (Q10)}} \text{=} \frac{\text{2 (1 +} \frac{{\text{R}}_{\text{8}}}{{\text{R}}_{\text{9}}} {\text{) v}}_{\text{T}} \text{ℓnN} \frac{{\text{r}}_{\text{2}}}{{\text{r}}_{\text{1}}}}{{\text{R}}_{\text{7}}}$

To simplify the equation (24), k₁ is used for the equation (25).${\text{I}}_{\text{C(Q10)}} {\text{=k}}_{\text{1}} {\text{v}}_{\text{T}}$ here, k₁ represents$\frac{\text{2 (1 +} \frac{{\text{R}}_{\text{8}}}{{\text{R}}_{\text{9}}} \text{) ℓnN} \frac{{\text{r}}_{\text{2}}}{{\text{r}}_{\text{1}}}}{{\text{R}}_{\text{7}}}$

Because I_{C(Q10)} is a constant current of the differential amplifier 9, the mutual conductance gₘ₅ is expressed as in the equation (26).${\text{g}}_{\text{m5}} \text{=} \frac{\text{I} {\text{}}_{\text{C} \left(\text{Q10}\right)}}{{\text{4v}}_{\text{T}}}$

Substituting the equation (25) into the equation (26), the following equation (27) is obtained.${\text{g}}_{\text{m5}} \text{=} \frac{{\text{k}}_{\text{1}}}{\text{4}}$

Substituting the equation (27) into the aforementioned equation (14), the following equation (28) which expresses the oscillation frequency f₀₅ of the circuit is obtained.${\text{f}}_{\text{05}} \text{=} \frac{\text{1}}{\text{2π} \sqrt{{\text{L}}_{\text{01}} {\text{(C}}_{\text{01}} {\text{+C}}_{\text{5}} {\text{+C}}_{\text{6}} {\text{+G}}_{\text{01}} {\text{· h}}_{\text{fe5}} {\text{· C}}_{\text{5}} {\text{· 4/k}}_{\text{1}} \text{)}}}$

In short, the oscillation frequency fₒ₅ expressed in this equation (28) is constant regardless of the temperature change because it does not contain the term of temperature T.

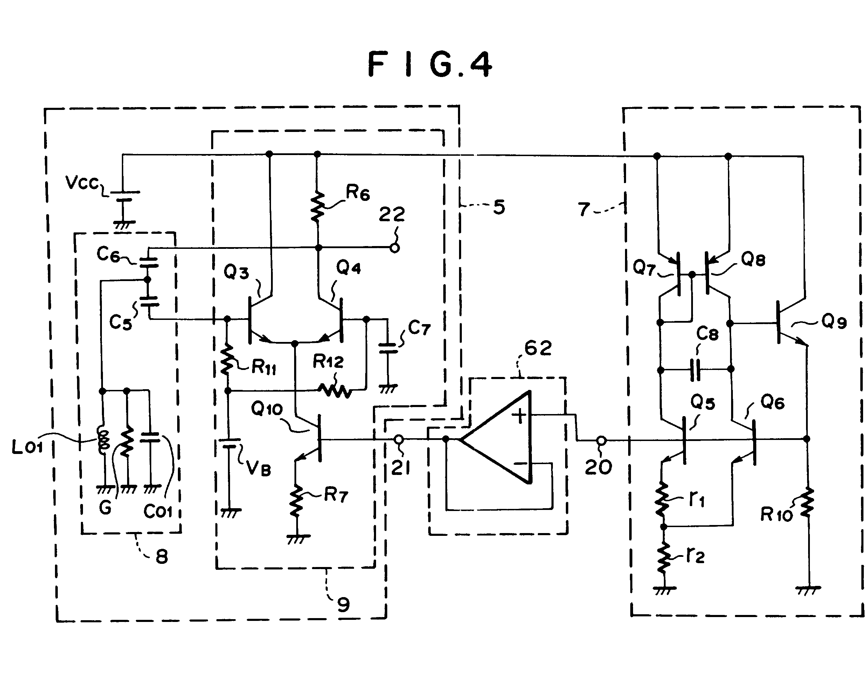

Fig. 4 shows another embodiment of the oscillation circuit according to the present invention. The only difference between this embodiment and the previous embodiment shown in Fig. 3 resides in that an operational amplifier 62 in this embodiment functions as a voltage-follower while the operational amplifier 6 in the previous embodiment functions as a non-inverting amplifier having a voltage gain of (R8+R9)/R9. The remaining circuit construction other than this operational amplifier 62 is the same as that of the first embodiment and, therefore, the aforementioned description of the operation can be applied to this embodiment, and the description is omitted here.

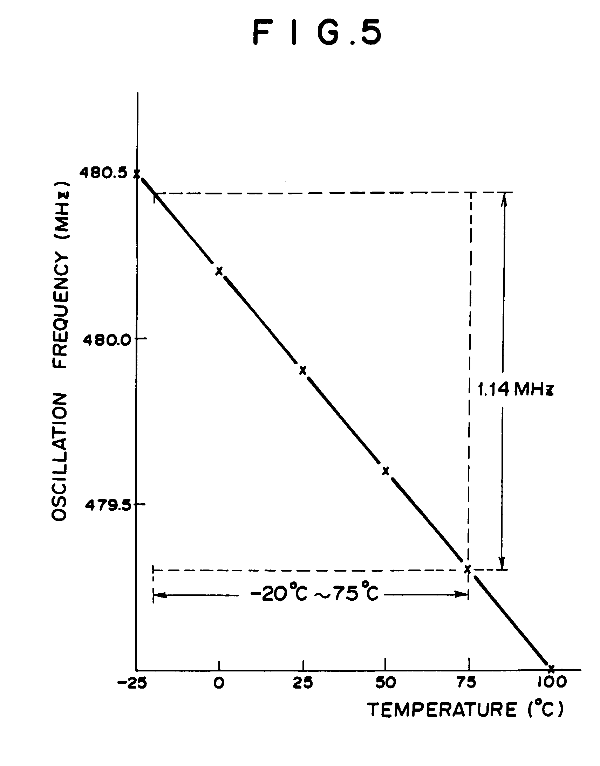

As described above, the current of the constant current source of the differential amplifier constituting a part of the oscillation circuit according to the present invention is set so as to be proportional to the thermal voltage of the transistor. Accordingly, any parameter relating to the temperature which has an influence on the oscillation frequency can be eliminated as shown in the equation (28). The invention therefore shows an effect in that the oscillation frequency is very stable against the temperature change. The characteristic of oscillation frequency versus temperature in the oscillation circuit experimentally obtained according to the present invention is shown in Fig. 5. It is apparent from Fig. 5 that in the case where the oscillation frequency at ordinary temperature is 480 MHz, the width of fluctuation of the oscillation frequency against the temperature change in a range of from -25°C to 75°C can be effectively reduced to 1.14 MHz.

While the invention has been described in its preferred embodiments, it is to be understood that the words which have been used are words of description rather than limitation and that changes within the purview of the appended claims may be made without departing from the true scope of the invention in its broader aspects.

## Claims

1. An oscillation circuit comprising an oscillator (5) which has a differential amplifier (9) including a constant current source having a resistor (R7) and a transistor (Q10) whose emitter is grounded through said resistor,
**characterized** by
a feedback circuit (8) through which an output of said differential amplifier (9) is positively fed back to an input of the same differential amplifier, said oscillator outputting an oscillation frequency which is determined by a circuit constant of said feedback circuit and mutual conductance of said differential amplifier and which has temperature dependency characteristic, said oscillation circuit further comprises:
a band-gap regulator (7) which includes a pair of first and second transistors (Q5, Q6) whose emitter areas are different from each other and which is for producing a band-gap voltage (V_{BG}) proportional to a thermal voltage of said pair of transistors (Q5,Q6) and
an operational amplifier (6; 62) connected between said band-gap regulator and said constant current source, for DC-amplifying said band-gap voltage and applying the amplified band-gap voltage to the base of said transistor (Q10) constituting the constant current source so that temperature dependency of the mutual conductance of said differential amplifier is eliminated.

2. An oscillation circuit according to claim 1, in which said operational amplifier (6) is a non-inverting amplifier which has an input resistor (R9) connected between an inverting input terminal (-) and a ground terminal, and a feedback resistor (R8) connected between an output terminal and said inverting input terminal (-).

3. An oscillation circuit according to claim 1, in which said operational amplifier (62) is a voltage-follower circuit with an output terminal being directly connected to an inverting input terminal (-).

4. An oscillation circuit according to claim 1, in which said band-gap regulator (7) includes a current mirror circuit having a third and a fourth transistor (Q7, Q8), a feedback circuit having a fifth transistor (Q9) and a resistor (R10), an output of said current mirror circuit being fed back to the respective bases of said first and second transistors (Q5, Q6).

5. An oscillation circuit according to claim 1, in which an emitter area ratio between said first and second transistors (Q5, Q6) in said band-gap regulator (7) is N : 1 (N being N>2).

## Patentansprüche

1. Oszillationsschaltung mit einem Oszillator (5) mit einem Differenzverstärker (9), der eine Konstantstromquelle mit einem Widerstand (R7) und einem Transistor (Q10) aufweist, dessen Emitter über den Widerstand geerdet ist,
**gekennzeichnet** durch
eine Rückkopplungsschaltung (8), durch die die Ausgabe des Differenzverstärkers (9) positiv an einen Eingang desselben Differenzverstärkers rückgekoppelt wird, wobei der Oszillator eine Oszillationsfrequenz ausgibt, die durch eine Schaltungskonstante der Rückkopplungsschaltung und die Steilheit des Differenzverstärkers bestimmt ist und eine Temperaturabhängigkeitscharakteristik aufweist, wobei die Oszillationsschaltung weiterhin aufweist:
einen Bandlückenregulator (7), der ein Paar aus einem ersten und einem zweiten Transistor (Q5, Q6) aufweist, deren Emitterbereiche sich voneinander unterscheiden, was zur Erzeugung einer Bandlückenspannung (V_{BG}) proportional zu einer thermischen Spannung des Transistorpaares (Q5, Q6) vorgesehen ist, und
einen Operationsverstärker (6; 62), der zwischen den Bandlückenregulator und die Konstantstromquelle geschaltet ist, zum Gleichstromverstärken der Bandlückenspannung und zum Anlegen der verstärkten Bandlückenspannung an die Basis des Transistors (Q10), der die Konstantstromquelle bildet, derart, daß die Temperaturabhängigkeit der Steilheit des Differenzverstärkers eliminiert wird.

2. Oszillationsschaltung nach Anspruch 1,
wobei der Operationsverstärker (6) ein nichtinvertierender Verstärker ist, der einen Eingangswiderstand (R9) aufweist, der zwischen einen invertierenden Eingangsanschluß (-) und einen Masseanschluß geschaltet ist, und einen Rückkopplungswiderstand (R8), der zwischen einen Ausgangsanschluß und den invertierenden Eingangsanschluß (-) geschaltet ist.

3. Oszillationsschaltung nach Anspruch 1,
wobei der Operationsverstärker (62) eine Spannungsfolgerschaltung mit einem Ausgangsanschluß ist, der direkt an einen invertierenden Eingangsanschluß (-) geschaltet ist.

4. Oszillationsschaltung nach Anspruch 1,
wobei der Bandlückenregulator (7) eine Stromspiegelschaltung mit einem dritten und einem vierten Transistor (Q7, Q8) aufweist, eine Rückkopplungsschaltung mit einem fünften Transistor (Q9) und einem Widerstand (R10), wobei die Ausgabe der Stromspiegelschaltung zu den jeweiligen Basen des ersten und des zweiten Transistors (Q5, Q6) rückgekoppelt wird.

5. Oszillationsschaltung nach Anspruch 1,
wobei das Emitterflächenverhältnis zwischen dem ersten und dem zweiten Transistor (Q5, Q6) in dem Bandlückenregulator (7) N:1 beträgt (wobei N > 2).

## Revendications

1. Circuit d'oscillation comprenant un oscillateur (5) qui comporte un amplificateur différentiel (9) incluant une source de courant constant comportant une résistance (R7) et un transistor (Q10) dont l'émetteur est mis à la masse par l'intermédiaire de ladite résistance,
caractérisé par un circuit à réaction (8) par lequel une sortie de l'amplificateur différentiel (9) est renvoyée positivement à une entrée du même amplificateur différentiel, ledit oscillateur sortant une fréquence d'oscillation qui est déterminée par une constante de circuit dudit circuit à réaction et une transconductance dudit amplificateur différentiel et qui a une caractéristique de dépendance en température, ledit circuit d'oscillation comprenant en outre :
un régulateur d'intervalle de bande (7) qui comprend une paire de premier et deuxième transistors (Q5, Q6) dont les surfaces d'émetteur sont différentes entre elles et qui sert à produire une tension d'intervalle de bande (VBG) proportionnelle à une tension thermique de ladite paire de transistors (Q5, Q6) ; et,
un amplificateur opérationnel (6 ; 62) connecté entre ledit régulateur d'intervalle de bande et ladite source de courant constant, pour amplifier en courant continu ladite tension d'intervalle de bande et appliquer la tension d'intervalle de bande amplifiée à la base dudit transistor (Q10) constituant la source de courant constant de telle sorte que la dépendance en température de la transconductance dudit amplificateur différentiel est éliminée.

2. Circuit d'oscillation selon la revendication 1, dans lequel ledit amplificateur opérationnel (6) est un amplificateur non-inverseur qui comporte une résistance d'entrée (R9) connectée entre une borne d'entrée inverseuse (-) et une borne de masse, et une résistance de réaction (R8) connectée entre une borne de sortie et ladite borne d'entrée inverseuse (-).

3. Circuit d'oscillation selon la revendication 1, dans lequel ledit amplificateur opérationnel (62) est un circuit suiveur de tension dont une borne de sortie est directement connectée à une borne d'entrée inverseuse (-).

4. Circuit d'oscillation selon la revendication 1, dans lequel ledit régulateur d'intervalle de bande (7) comprend un circuit miroir de courant comportant un troisième et un quatrième transistor (Q7, Q8), un circuit à réaction comportant un cinquième transistor (Q9) et une résistance (R10), une sortie dudit circuit miroir de courant étant renvoyée aux bases respectives desdits premier et deuxième transistors (Q5, Q6).

5. Circuit d'oscillation selon la revendication 1, dans lequel le rapport des surfaces d'émetteur entre lesdits premier et deuxième transistors (Q5, Q6) dans ledit régulateur d'intervalle de bande (7) est N:1 (N étant N > 2).
